# EUROPÄISCHE PATENTSCHRIFT

(11) **EP 1 358 702 B1**
(45) Veröffentlichungstag und Bekanntmachung des Hinweises auf die Patenterteilung: **13.03.2013**
(21) Anmeldenummer: 02716657.8
(22) Anmeldetag: 12.01.2002
(51) Int. Cl.: H02B 1/50

(54) **BAUSATZ UND VERFAHREN ZUM ERSTELLEN EINES ELETROSCHRANKES FÜR DEN AUSSENBEREICH**
KIT AND METHOD FOR CONSTRUCTING AN ELECTRIC POWER CABINET FOR AN OUTDOOR AREA
ENSEMBLE ET PROCEDE POUR CONSTRUIRE UNE ARMOIRE ELECTRIQUE DESTINEE A L'EXTERIEUR

(30) Priorität: 09.02.2001 DE 10105993
(43) Veröffentlichungstag der Anmeldung: 05.11.2003
(73) Patentinhaber: Tyco Electronics Services GmbH, 8200 Schaffhausen (CH); Berthold Sichert GmbH, 12277 Berlin (DE)
(72) Erfinder: IRMER, Günter, 13055 Berlin (DE)
(74) Vertreter: Alber, Norbert
(86) Internationale Anmeldenummer: PCT/EP2002/000248
(87) Internationale Veröffentlichungsnummer: WO 2002/075883

(56) Entgegenhaltungen:
- EP-A- 1 047 167
- FR-A- 2 776 850

## Beschreibung

### I. Anwendungsgebiet

Die Erfindung betrifft einen Elektroschrank, der in der Regel im Freien aufgestellt ist und die Verteilanlagen für Schwachstromsysteme, beispielsweise Telefonanlagen, mit zugehörigen Stromversorgungseinrichtungen und Kabelab-/-anschlusseinrichtungen für ein bestimmtes räumliches Gebiet aufnimmt.

### II. Technischer Hintergrund

Derartige Elektroschränke müssen unterschiedliche Bedingungen erfüllen, da sie die Betriebsbedingungen, insbesondere die Temperatur, der in ihnen untergebrachten elektrischen Komponenten, insbesondere der elektronischen Komponenten, einzuhalten helfen müssen, da sie in unterschiedlichen Staaten/Regionen eingesetzt werden, und von den jeweiligen Betreibern unterschiedliche technische Vorgaben bzw. Normungen existieren, die eingehalten werden müssen oder weil in der beabsichtigten Region bestimmte klimatische Besonderheiten bestehen, die berücksichtigt werden müssen.

Daneben müssen allgemeine Forderungen wie ausreichende bauliche Stabilität und Widerstandsfähigkeit gegen Vandalismus etc. erfüllt sein.

Derartige Elektroschränke werden grundsätzlich entweder aus Metall oder aus Kunststoff bzw. aus beiden Materialien hergestellt, wobei Kunststoff den Vorteil einer billigeren Herstellbarkeit mit dem Vorteil eines geringeren Gewichts und eines elektrisch nicht leitenden Materials verbindet.

Daneben besteht das Problem, dass derartige Elektroschränke nicht auf dem blanken Erdboden montiert werden, sondern auf oder an sogenannten Sockelkästen, die ganz oder teilweise im Erdboden vergraben sind und der Herausführung der Erdkabel aus dem Untergrund dienen.

Abgesehen von der unterschiedlichen Dimensionierung dieser Sockelkästen und der unterschiedlichen Höhe des Aufragens (Oberkante ebenerdig Erdoberfläche oder darüber vorstehend), bestehen auch unterschiedliche Forderungen hinsichtlich des Zusammenwirkens mit derartigen Sockelkästen: Im einen Fall soll der Elektroschrank auf dem Sockelkasten aufsitzen, im anderen Fall soll der Sockelkasten nicht sichtbar sein, also der Elektroschrank den Sockelkasten auf den Seiten sowie oben umhüllen.

Dies soll vor allem Tiefbauarbeiten dahingehend vermeiden helfen, dass keine Sockelkästen einer früheren, veralteten, Bauform gegen neue, zu den Elektrokästen passende, Sockel ausgetauscht werden müssen.

Um zu vermeiden, dass je nach vorhandenen Randbedingungen ein separater Elektroschrank konzipiert und gebaut werden muss, besteht die Aufgabe der Erfindung darin, einen solchen Bausatz sowie ein Verfahren zum Erstellen von Elektroschränken zu schaffen, welches die Anpassung an die unterschiedlichen Randbedingungen mit nur wenigen Einzelteilen ermöglicht.

Die unterschiedlichen Bau- und Montagevarianten, die erzielbar sein sollen, sind folgende:
- Aufsetzen des Elektroschrankes auf der Oberseite eines ebenerdig endenden Sockelkastens,
- Aufnehmen eines aus der Oberfläche aufragenden Sockelkastens im unteren Bereich des Elektroschrankes, dabei Aufnahme zumindest im äußeren Korpus des Elektroschrankes, besser im Inneren des Montagerahmens,
- Abschottung des Aufnahmeraumes, also des Raumes innerhalb des Montagerahmens, gegenüber dem Zwischenraum, nämlich des Abstandes zwischen dem Montagerahmen und des außen umgebenden äußeren Korpus; dabei muss unterschieden werden zwischen der Abschottung zu den Seiten hin und der Abschottung nach oben,
- Anordnung der Sollbruchelemente zwischen Sockelkasten und Elektroschrank oder innerhalb des mehrteiligen Sockelkastens,
- Ausstattung des äußeren Korpus mit oder ohne oberem Zwischenteil zwischen dem Deckel und den darunterliegenden Teilen des Korpus,
- Ausstattung des Elektroschrankes mit oder ohne EMV-Abschirmung.

Weiterhin ist es auch der DE 73 19 283 U als nächstreichendem Stand der Technik bekannt, den Montagerahmen eines Elektroschrankes höhenverstellbar gegenüber dem Untergrund zu befestigen. Dies geschieht jedoch nicht über Befestigung an unterschiedlichen Positionen des Montagerahmens, und auch unterschiedlich dimensionierte und unterschiedlich hoch aufragende Sockelkästen sind dabei nicht vorgesehen.

Unterschiedliche Montagehöhen des Sockels am Elektroschrank zeigt dagegen FR 2 785 100, wobei dort der Elektroschrank keinen Montagerahmen aufweist.

DE 296 23 678 U1 zeigt desweiteren die Verwendung unterschiedlicher Sockelkästen, wenngleich dabei bei Verwendung mehrerer Sockelkästen insgesamt immer die gleichen Gesamtabmessungen der Sockel in der Aufsicht betrachtet erzielt werden.

Darüberhinaus zeigt DE 295 19 260 U einen doppelwandigen Schaltschrank mit Abstand zwischen Außenhaut und Innenhaut des Schaltschrankes und dazwischen stattfindender Luftzirkulation.

DD 39 240 A zeigt einen Elektroschrank mit einem inneren Montagerahmen aus Profilen, zwischen dessen äußerer Beplankung und dessen Deckel Entlüftungsöffnungen bestehen.

Darüberhinaus zeigt DE 32 05 934 eine aus mehreren Elementen zusammensetz-bare Bodenplatte für einen Elektroschrank.

### III. Darstellung der Erfindung

### a) Technische Aufgabe

Es ist daher die Aufgabe gemäß der Erfindung, einen Bausatz zum Erstellen eines Elektroschrankes zur Verfügung zu stellen, der wahlweise unterschiedliche Vorgaben hinsichtlich Grundfläche und Überstand des Sockels über die Erdoberfläche sowie der EMV-Abschirmung und Be- und Entlüftung erfüllen kann.

### b) Lösung der Aufgabe

Diese Aufgabe wird durch die kennzeichnenden Merkmale der Ansprüche 1 und 24 gelöst. Vorteilhafte Ausführungsformen ergeben sich aus den Unteransprüchen.

Um den Elektroschrank auf unterschiedlich hoch über die Erdoberfläche aufragenden Sockelkästen befestigen zu können, insbesondere auch auf ebenerdig mit der Erdoberfläche abschließenden, also nicht darüber aufragenden, Sockelkästen, können die Auflageplatten, die die Verbindung zwischen Montagerahmen und Sockelkasten herstellen, an unterschiedlichen Befestigungspositionen des Montagerahmens angeordnet werden. Diese Befestigungspositionen unterscheiden sich zunächst hinsichtlich der Höhe am Montagerahmen, denn sie können entweder an den unteren Querstreben des Montagerahmens angeordnet sein. In diesem Fall sitzt der Elektroschrank später auf der Oberseite des Sockelkastens auf. Bei einem ebenerdig abschließenden Sockelkasten, also mehr oder weniger auf der Erdoberfläche, bei einem über die Erdoberfläche aufragenden Sockelkasten würde sich der Elektroschrank von der Oberkante des Sockelkastens aus nach oben erstrecken.

Weiterhin unterscheiden sich die unterschiedlichen Sockelkästen in ihrer Breite, also in Querrichtung, der großen Grundflächendimensionierung, betrachtet als auch in der Tiefe, der kleineren Grundflächendimensionierung.

Da speziell die Dimensionierung der Tiefe sehr unterschiedlich ist, muss nicht die lichte, innere Weite des Montagerahmens, innerhalb der der Sockelkasten untergebracht werden soll, nach der größten Tiefe der Sockelkästen bemessen sein, sondern der Montagerahmen kann demgegenüber etwas weniger tief gestaltet sein, indem eine der unteren Querstreben des Montagerahmens entfernbar ist, also bei sehr tiefen Sockelkästen die Dicke der Querstrebe noch hinzugenommen wird, um den Sockelkasten dann zwar noch innerhalb des äußeren Korpus des Elektroschranks unterzubringen, nicht mehr jedoch komplett innerhalb des Montagerahmens. Die Stabilität des Montagerahmens wird dadurch zwar verringert, liegt jedoch noch innerhalb der akzeptablem Grenzen, vor allem auch aufgrund der Tatsache, dass zwischen den oberen und unteren Querstreben mittlere Querstreben in Querrichtung zwischen den vertikalen Kanten und den dort vorhandenen Vertikalstreben des Montagerahmens zur Versteifung vorhanden sind. Bevorzugt wird jedoch der Montagerahmen, in der Aufsicht betrachtet, um den Sockelkasten herum verlaufen, also werden auch beide Querstreben vorhanden sein.

Diese Querstreben werden auf einer solchen Höhe des übrigen Montagerahmens angeordnet, die der Höhe der Oberkante des Sockelkastens - bei über die Erdoberfläche aufragenden Sockelkästen - entspricht.

Die Auflageplatten werden dann an diesen Querstreben durch Verschrauben befestigt, und nach Aufsetzen des Montagerahmens auf dem Sockelkasten werden diese Auflageplatten, die von der vorderen zur hinteren Querstrebe durchgehen, auf der Oberseite des Sockelkastens befestigt.

Der Abstand der Auflageplatten richtet sich nach der Breite des Sockelkastens, so dass die Auflageplatten nahe der äußeren Enden der Oberseite des Sockelkastens befestigt werden, um eine gute Stützwirkung zu erzielen.

Sofern es sich um einen Sockelkasten handelt, der nicht oder nur geringfügig über die Erdoberfläche aufragt bzw. wenn der Elektroschrank auf der Oberseite des Sockelkastens aufsitzen soll, werden diese Auflageplatten an den unteren Querstreben befestigt.

Ferner ist zu unterscheiden, ob der Aufnahmeraum im Inneren des Montagerahmens gegenüber dem umgebenden Zwischenraum zwischen Montagerahmen und äußerem Korpus thermisch, also hinsichtlich der Luftzirkulation und/oder hinsichtlich der elektromagnetischen Abstrahlung, abgetrennt werden soll. Für eine thermische Abtrennung wird der innere Montagerahmen 6 mit flächigen, geschlossenen Platten, vorzugsweise auf der Außenseite des Montagerahmens oder auch auf dessen Innenseite, beplankt. Dies geschieht auf der Rückseite und den Seitenwänden. Die Frontwand, in der in der Regel der äußere Korpus eine oder mehrere Türen zum Öffnen des Elektroschrankes aufweist, muss auch hinsichtlich einer solchen Beplankung am inneren Montagerahmen mit analogen zu öffnenden Elementen, also Türen oder Klappen etc., ausgestattet werden.

Ferner ist zu unterscheiden, ob dieser innere Aufnahmeraum auch an der Oberseite, also am oberen Ende des Montagerahmens, thermisch durch eine geschlossene Platte gegenüber dem darüberliegenden Deckelraum des umgebenden Korpus abgetrennt sein soll oder nicht. In diesem Fall ist eine Beplankung auch der Oberseite des inneren Montagerahmens notwendig. Dies kann durch ein separates Beplankungsteil oder auch durch Aufsetzen eines Zwischenteiles zwischen dem Deckel des äußeren Korpus und dem Rest des Korpus erfolgen, sofern dieses Zwischenteil eine durchgehende untere Platte aufweist und trotz der Befestigung an den übrigen Teilen des äußeren Korpus dicht auf der Oberseite des inneren Montagerahmens aufsetzbar ist.

Dies muss dadurch gewährleistet werden, dass die zwecks Befestigung des äußeren Korpus am inneren Montagerahmen verwendeten Verbindungselemente ein Aufsetzen dieses Zwischenteiles auf der Oberseite des Montagerahmens zulassen.

Der äußere Korpus besteht in der Regel aus plattenförmigen Einzelteilen für die einzelnen Wände und auf der Frontseite zusätzlich durch gegenüber der Frontplatte beweglichen einen oder mehreren Türen, sowie einem separaten oberen Deckel.

Der äußere Korpus, insbesondere dessen plattenförmige Einzelteile, bestehen in der Regel aus Kunststoff, insbesondere zur Verbesserung der Isolation aus geschäumtem Kunststoff, insbesondere geschäumten Polykarbonat.

Daneben kann der Bausatz auch einen äußeren Korpus und insbesondere plattenförmige Einzelteile eines solchen äußeren Korpus aus Metall, insbesondere Stahlblech oder Aluminiumblech, umfassen.

Dabei weist der äußere Korpus im unteren Bereich Eintrittsöffnungen für die Umgebungsluft in den Zwischenraum auf. Ausströmöffnungen sind zwischen Deckel und dem Rest des äußeren Korpus vorhanden oder in dem oberen Zwischenteil, wobei ein Einströmen der im Zwischenraum nach oben aufsteigenden Luft - aufgrund Erwärmung durch Sonneneinstrahlung auf die Außenseite der Korpusteile - von dem Zwischenraum in das obere Zwischenteil durch Durchtrittsöffnungen ermöglicht sein muss.

Die unteren Eintrittsöffnungen können auch dadurch realisiert sein, dass zwischen dem unteren Ende der Wände des äußeren Korpus und dem Erdboden ein Abstand besteht, der zum Eintreten der Luft in den Zwischenraum dient.

Somit sind mehrere thermische Zirkulationsmodelle realisierbar: Wenn der innere Aufnahmeraum seitlich als auch oben gegenüber dem umgebenden Zwischenraum abgetrennt ist, wird - in Gang gesetzt durch die Abwärme der im inneren Aufnahmeraum angeordneten aktiven elektrischen Elemente wie Verlustwärme der Steuerungselektronik etc. - ein in diesem inneren Montageraum ausschließlich stattfindender Luftkreislauf etabliert. Diesem Kreislauf wird Wärme entzogen, indem der Kreislauf die Beplankung des Montagerahmens erwärmt, und diese Beplankung gekühlt wird, indem außen, im Zwischenraum zwischen Beplankung des Montagerahmens und äußerem Korpus, Luft aus der Umgebung unten einströmt und oben, gegebenenfalls über das obere Zwischenteil und gegebenenfalls mittels aktiver Kühlung durch das Zwischenteil (einem Lüfter, der die Zirkulation zwischen äußerem Korpus und innerem, beplanktem und gegenüber dem Zwischenraum zum äußeren Korpus abgeschotteten, Montagerahmen beschleunigt oder einem Wärmetauscher bzw. Kühlelement in der Beplankung des inneren Montagerahmens, insbesondere dessen oberem Abschluss, wobei jedoch die Abschottung zwischen innerem Montageraum und dem äußeren Zwischenraum zwischen beplanktem Montagerahmen und Korpus erhalten bleiben soll) wieder ausströmt.

Sofern der innere Aufnahmeraum nur seitlich gegenüber dem Zwischenraum mittels Beplankung abgeschottet ist, umfasst dieser innere Kreislauf auch den Deckelraum, also den Raum zwischen dem Deckel des äußeren Korpus und den übrigen Korpusteilen. In der Regel jedoch ist der Montagerahmen auch oben beplankt und damit sowohl oben als auch an den Seiten und somit vollständig gegenüber dem äußeren Zwischenraum, also dem Raum zwischen Beplankung des Montagerahmens und dem umgebenden Korpus, abgeschottet.

Auch die Vorgehensweise bei der Montage des Elektroschranks am Sockelkasten kann unterschiedlich sein:

Sofern der Elektroschrank den Sockelkasten nicht umschließen, sondern lediglich von dessen Oberseite aus nach oben aufragen soll, ist ein einfaches Aufsetzen - zunächst des Montagerahmens - selbstverständlich, wobei in der Regel erst anschließend der äußere Korpus und/oder der innere Ausbau des Montagerahmens einschließlich der Baugruppenträger stattfindet.

Soll der Elektroschrank dagegen den über die Erdoberfläche vorstehenden Sockelkasten umschließen, sind unterschiedliche Vorgehensweisen möglich:

Sofern die nur schwer biegsamen Erdkabel über die Oberseite des Sockelkastens heraus vorstehen, wird ein Überstülpen des Elektroschrankes, also zunächst dessen Montagerahmen, von oben her über den Sockelkasten bevorzugt.

Sofern jedoch - was in der Regel nicht der Fall ist - der Sockelkasten von der Grundfläche her größer ist als der lichte Innenraum des Montagerahmens, ist dies nicht möglich.

Dann bietet sich ein horizontales Überschieben des Montagerahmens über den nach oben vorstehenden Teil des Sockelkastens an, wobei hierzu eine der unteren Querstreben des Montagerahmens vorher von diesem demontiert werden muss und auch entfernt bleibt, sofern die Grundfläche des Sockelkastens größer ist als der lichte Innenraum zwischen den montierten unteren Querstreben des Montagerahmens.

Sofern ein vorhandener, über die Erdoberfläche vorstehender Sockelkasten noch keine Sollbruchelemente zwischen herausragendem und im Erdboden befindlichem Teil des Sockelkastens umfasst, müssen derartige Sollbruchelemente bei der Befestigung des Elektroschranks am Sockelkasten vorgesehen werden, beispielsweise zwischen den Auflageplatten und dem Sockelkasten.

### c) Ausführungsbeispiele

Ausführungsformen gemäß der Erfindung sind im folgenden anhand der Figuren beispielhaft näher beschrieben. Es zeigen:
- Fig. 1:: Prinzipdarstellungen der Montageversionen im Schnitt,
- Fig. 2:: thermische Kreisläufe im Elektroschrank im Schnitt,
- Figuren 3:: Einzelansichten des Montagezustandes ohne äußeren Korpus,
- Figuren 4:: Einzelansichten gemäß Figuren 3 mit äußerem Korpus,
- Fig. 5:: eine perspektivische Ansicht des Zustandes der Fig. 3,
- Fig. 6:: die perspektivische Ansicht im weiter fortgeschrittenen Montagezustand,
- Fig. 7:: eine perspektivische Ansicht des teilweise montierten Schaltschrankes auf einem Sockel gemäß Fig. 1 b und
- Fig. 8:: eine perspektivische Ansicht des Schaltschrankes gemäß Fig. 7 nach vollständiger Montage.

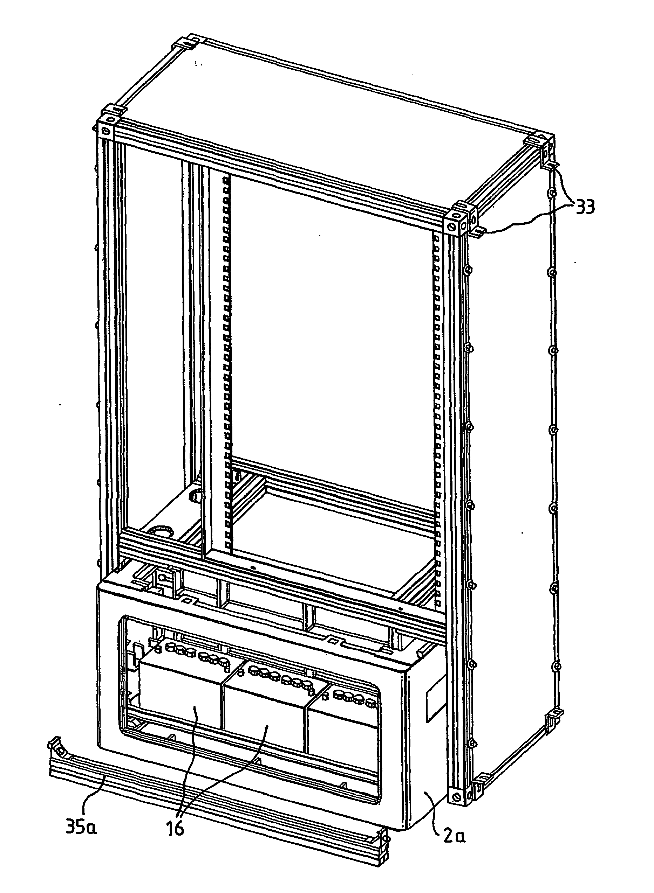

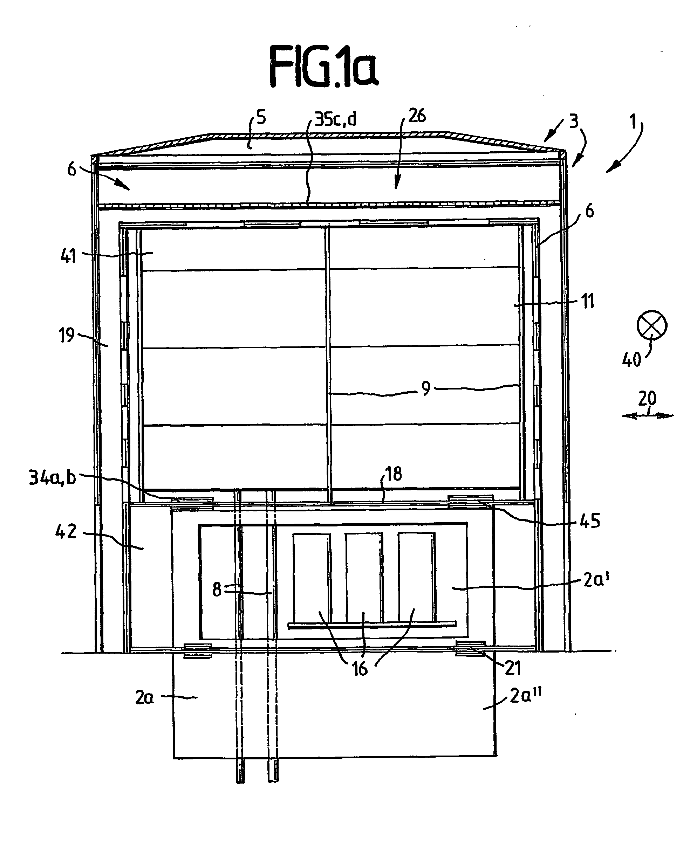

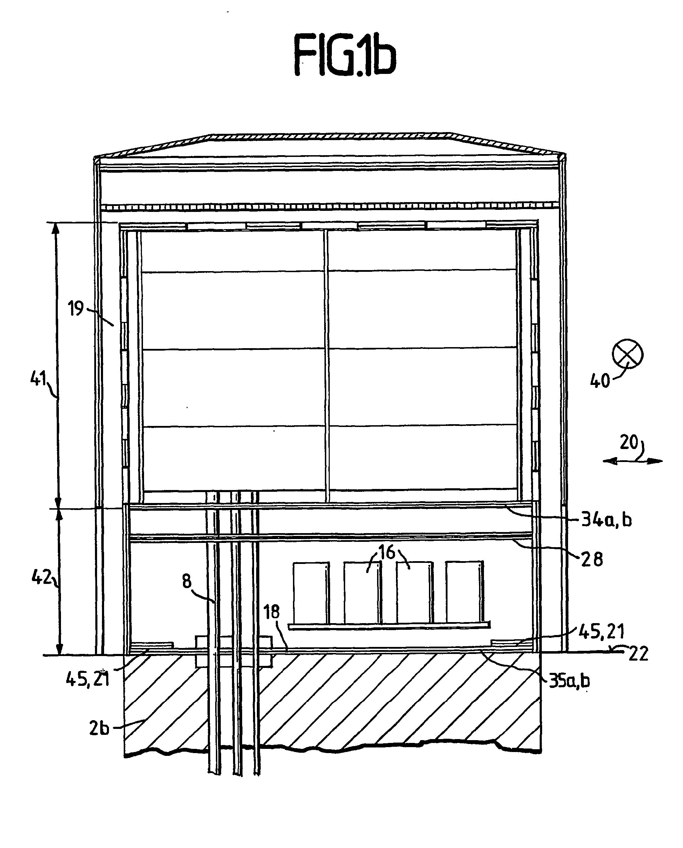

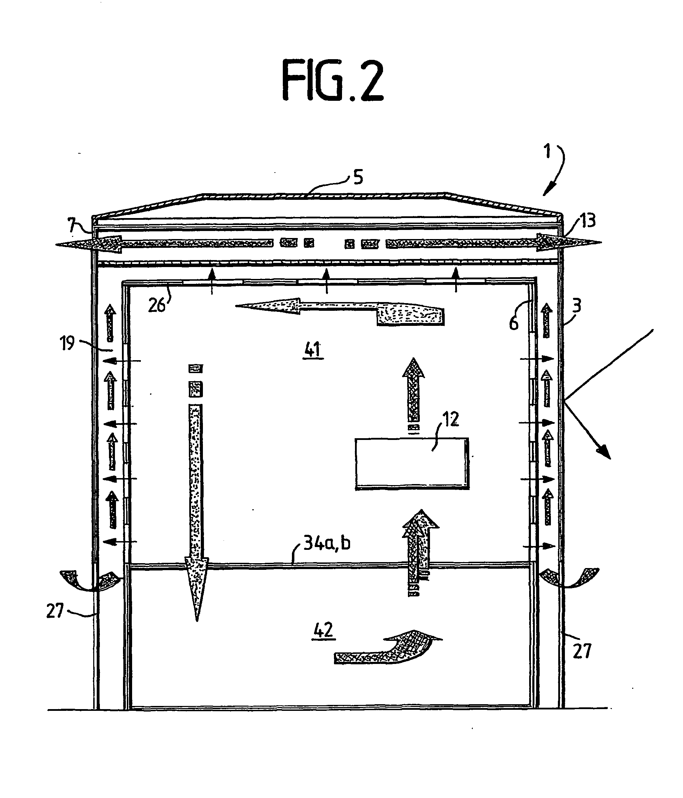

Die Figuren 1 und 2 zeigen Elektroschränke 1 betrachtet mit Blickrichtung in die Tiefe 40 dieser Elektroschränke, jeweils aufgeschnitten entlang der Querrichtung 20, der größten horizontalen Erstreckungsrichtung dieser Elektroschränke.

Fig. 1a zeigt das Montageschema eines überbauten Sockelkastens 2a. Dieser Sockelkasten 2a ragt teilweise über die Erdoberfläche 22 nach oben hinaus. Der hinausstehende Teil 2a' ist gegenüber dem im Erdboden eingelassenen Teil 2a" meist über Sollbruchelemente 21 verbunden, damit beim Anfahren durch ein Auto etc. das Abreißen des oberen Teiles 2a' nicht auch den im Erdboden liegenden Teil 2a" beschädigt oder verlagert.

Der Sockelkasten 2a ist meist oben und unten offen und dient der Herausführung der Erdkabel 8, die im Untergrund verlegt sind, mit ihrem freien Ende nach oben in Richtung des dort anzubringenden Elektroschranks, sowie als standfestes Fundament für den aufzubringenden Elektroschrank.

Weiterhin können im Inneren des Sockelkastens, insbesondere innerhalb dessen oberen Teiles 2a', zusätzliche Elemente, beispielsweise Batterien 16, untergebracht sein, die eine Energieversorgung der Steuerungskomponenten des Elektroschrankes auch bei Stromausfall über eine gewisse Zeit sicherstellen sollen.

Der Elektroschrank 1 umschließt dabei den über die Erdoberfläche 22 nach oben vorstehenden oberen Teil 2a' des Sockelkastens 2a. Der innere Montagerahmen 6 des Elektroschrankes 1 ist in der Regel aus einzelnen Streben zusammengesetzt, die entlang der Außenkanten der kubischen Form dieses Montagerahmens 6 verlaufen und meist aus metallenen Profilstreben, etwa aus Aluminium, bestehen. Der Innenraum dieses Montagerahmens 6 dient der Aufnahme von Baugruppen wie Sicherungen und Steuerungen in wenigstens einem Teil dieses Aufnahmeraumes. Bei über die Erdoberfläche 22 vorstehenden Sockelkästen 2a wird der obere Teil 2a' des Sockelkastens 2a in den unteren Aufnahmeraum 42 des Montagerahmens 6 aufgenommen, der zu diesem Zweck, beispielsweise mittels in Querrichtung verlaufenden Querstreben 34a,b gegenüber dem oberen Aufnahmeraum 41, der zur Aufnahme der Baugruppen des Elektroschrankes dient, abgetrennt ist.

Wie Fig. 1a zeigt, sitzt der Montagerahmen 6 mit seinen zwischen dem oberen und unteren Ende verlaufenden mittleren Querstreben 34a,b und den darin in Richtung der Tiefe 40 verlaufenden Auflageplatten 45 auf der Oberseite des oberen Teils 2a' des Sockelkastens 2a auf, so dass sich die vertikalen Eckstreben des Montagerahmens neben dem oberen Teil 2a' des Sockelkastens 2a weiter nach unten bis knapp über die Erdoberfläche erstrecken. Die Auflageplatten 45 sind an den Querstreben 34 von deren freien Enden soweit nach innen zurückversetzt befestigt, dass sie noch im Quererstreckungsbereich des Sockelkastens 2a liegen.

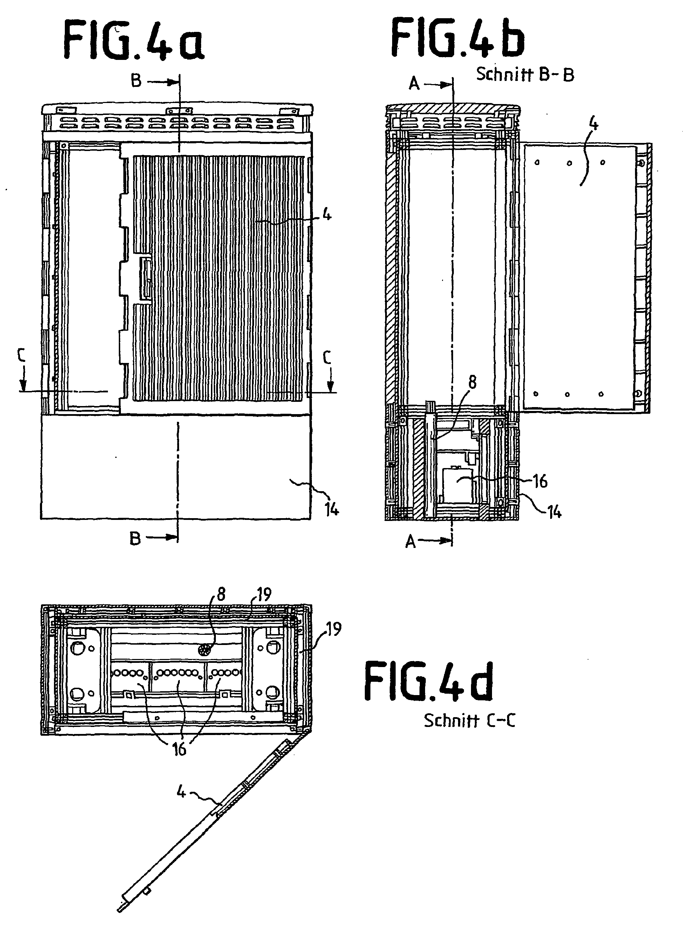

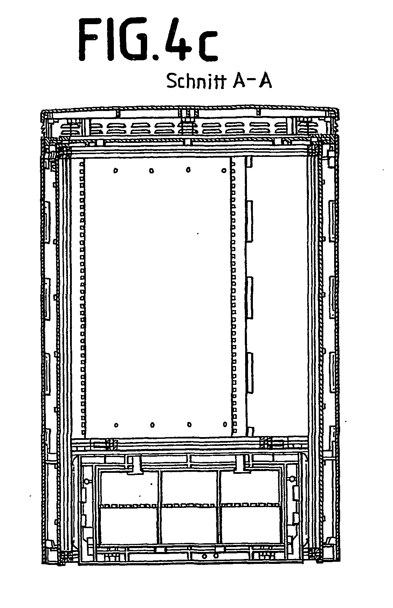

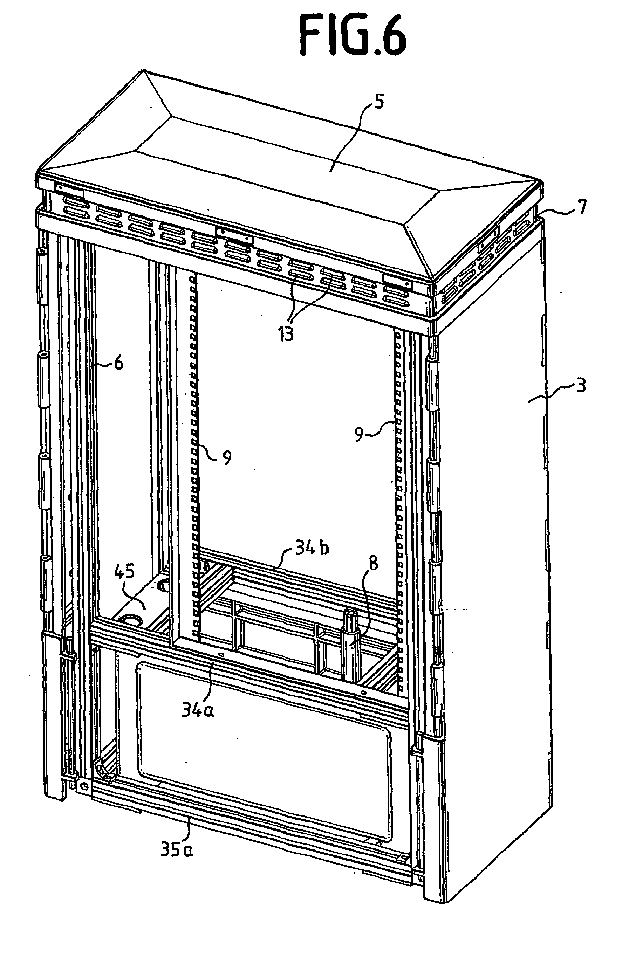

Im Höhenbereich des oberen Aufnahmeraums 41 sind Baugruppenträger 9 in Form von vertikal verlaufenden Streben zwischen den oberen Querstreben 35c,d und den mittleren Querstreben 34a,b verschraubt, an denen Trägerplatten 11 angeordnet werden können, die die einzelnen elektronischen oder elektromechanischen Baugruppen tragen. Über diesen - wie später beschriebenen gegebenenfalls beplankten - Montagerahmen 6 ist der äußere Korpus 3 gestülpt, der den äußeren Schutz, insbesondere Wetterschutz, des Elektroschrankes darstellt und auch zu dessen Klimatisierung dient, wie nachfolgend beschrieben. Der äußere Korpus 3 besteht häufig aus Kunststoff und ist dabei - wie vor allem die Figuren 4 und 6 zeigen - aus einzelnen Platten für Rückwand, Seitenwände, Türen und Deckel zusammengebaut.

Auf Höhe der mittleren Querstreben 34 kann zusätzlich der obere Aufnahmeraum 41 vom unteren Aufnahmeraum 42 durch ein Bodenblech 18 abgetrennt sein, welches jedoch die entsprechenden Durchlässe für die Erdkabel 8 besitzen muss.

Das Montageschema der Fig. 1b beruht demgegenüber auf einem Sockelkasten 2b, der einerseits mit seiner Oberseite auf Höhe der Erdoberfläche 22 endet, also sich vollständig innerhalb des Erdbodens befindet, und darüber hinaus eine andere, in der Regel größere, Grundflächenausdehnung, zumindest in Querrichtung 20, besitzt. In diesem Fall wird der Elektroschrank 1 mit seinen untersten horizontalen Streben auf der Oberseite des vollständig im Boden versenkten Sockelkastens 2b befestigt, wobei wiederum die Auflageplatten 45 in Richtung der Tiefe 40 zwischen der vorderen und der hinteren, unteren Querstrebe 35a,b befestigt werden, und zwar soweit in Querrichtung 20 nach außen gesetzt, dass sie auf den Enden der Oberseite des Sockelkastens 2b aufliegen.

Im mittleren Bereich ist dabei der Montagerahmen 6 vorzugsweise nach wie vor mittels mittlerer Querstreben 34a,b versteift, jedoch kann nunmehr der unterhalb dieser mittleren Querstreben befindliche Aufnahmeraum 42 wahlweise ebenfalls für die Aufnahme von elektrischen Baugruppen verwendet werden, auch für die Aufnahme von Batterien 16. In diesem unteren Aufnahmeraum kann auch ein horizontal am Montagerahmen 6 befestigtes Element zum Fixieren der Lage der Erdkabel vorhanden sein, beispielsweise eine Kabelbefestigungsschiene 28.

Die Anordnung der übrigen Elemente in Relation zur Erdoberfläche 22 ist die gleiche wie bei Fig. 1a. Unterschiedlich ist die Anordnung der Sollbruchelemente 21, die nunmehr zwischen den Auflageplatten 45 und dem Sockelkasten 2b angeordnet sind.

Fig. 2 zeigt in gleicher Schnittdarstellung die Montageform gemäß Fig. 1 b, jedoch im Hinblick auf die innerhalb des Elektroschrankes 1 nunmehr stattfindende Luftzirkulation, bedingt durch ungleichmäßige Erwärmung:

Zum Einen ist der äußere Korpus 3 dabei der Sonneneinstrahlung ausgesetzt. Zum anderen sind zumindest im oberen Aufnahmeraum 41 elektrische Baugruppen 12 angeordnet, die Energieverbraucher sind und Abwärme produzieren und damit den Aufnahmeraum 41 aufheizen.

Sofern der obere Aufnahmeraum 41 gegenüber dem unteren Aufnahmeraum 42 offen ist, also dazwischen nur auf den Seiten die Querstreben 34a,b vorhanden sind, entsteht im Inneren des Montagerahmens 6 ein sich über beide Aufnahmeräume 41,42 erstreckender vertikaler Kreislauf, in dem die erwärmte Luft aufsteigt, sich an dem oberen Rahmendeckel 26 abkühlt und nach unten sinkt.

Getrennt hiervon existiert eine Luftströmung im umgebenden Zwischenraum 19 zwischen dem Montagerahmen 6 und dem äußeren Korpus 3, sofern der Montagerahmen 6 zu diesem Zweck außen mit Kunststoffplatten oder anderen durchgehenden Platten beplankt ist. Sofern diese Beplankung zusätzlich eine EMV-Abschirmung bieten soll, ist hierfür eine metallische Abdeckung oder zumindest eine Ausstattung mit Metallfolie notwendig.

Für die Zugänglichkeit des Innenraumes des Montagerahmens 6 muss die Beplankung dieses Montagerahmens 6 ebenfalls innere Türen oder Klappen aufweisen.

Die Luftströmung im Zwischenraum 19 ist kein geschlossener Kreislauf, sondern die Luft dringt hier durch Eintrittsöffnungen 27 im unteren Bereich des Korpus 3 in den Zwischenraum 19 ein, beispielsweise - wie in der rechten Seite der Fig. 2 dargestellt - indem die Außenwände des Korpus 3 nicht ganz bis zum Boden herabreichen.

Im oberen Bereich des Korpus sind Luftaustrittsöffnungen 13 vorhanden, entweder zwischen dem Deckel 5 und den Seitenwänden des Korpus 3 oder in einem oberen Zwischenteil 7, welches zwischen Deckel 5 und den Rest des Korpus 3 gesetzt wird, und zusätzliche aktive oder passive Kühl- oder Heizkomponenten aufweisen kann.

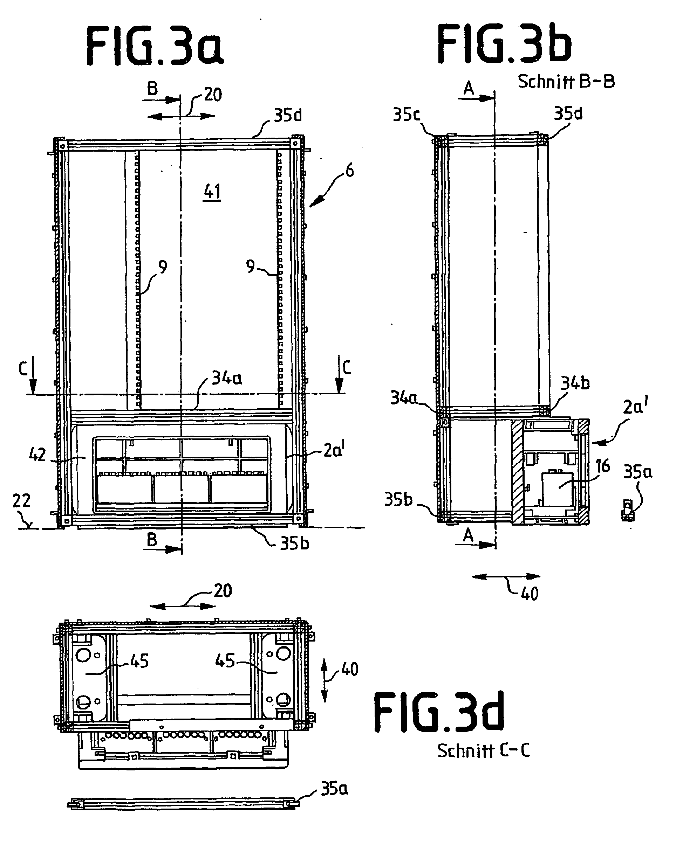

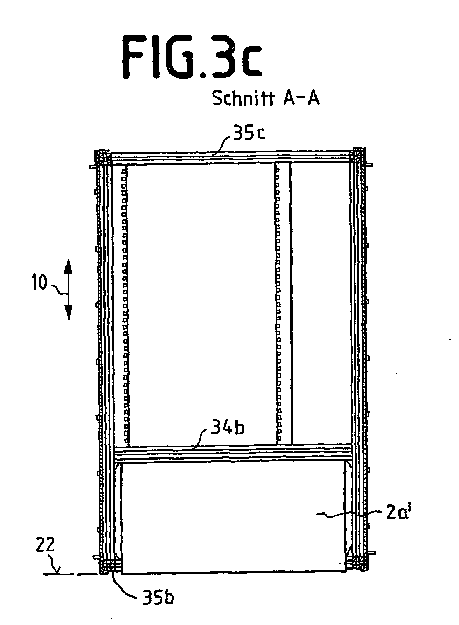

Die Figuren 3 zeigen die Montagesituation der Fig. 1 a, also mit teilweise über die Erdoberfläche 22 aufragendem Sockelkasten 2a, bei noch nicht vollendeter Befestigung des Montagerahmens 6 am Sockelkasten 2a in der Rückansicht (Fig. 3a), Seitenansicht (Fig. 3b), Frontansicht (Fig. 3c) und Aufsicht (Fig. 3d).

Wie vor allem die Figuren 3a-c zeigen, sind dabei zwischen die Vertikalstreben des Montagerahmens 6 mittlere Querstreben 34a,b in Querrichtung 20 verlaufend eingebaut. An dem Montagerahmen, insbesondere an diesen Querstreben 34a,b sind Auflageplatten 45 befestigt, die von der vorderen zur hinteren Querstrebe 34a,b, also in Richtung der Tiefe 40 des Elektroschrankes 1, verlaufen. Die Höhe der Querstreben 34a,b ist so gewählt, dass beim Aufsetzen der Auflageplatten 45 auf die Oberseite des oberen Teiles 2a' des Sockelkastens 2a der Montagerahmen 6 knapp oberhalb der Erdoberfläche 22 endet.

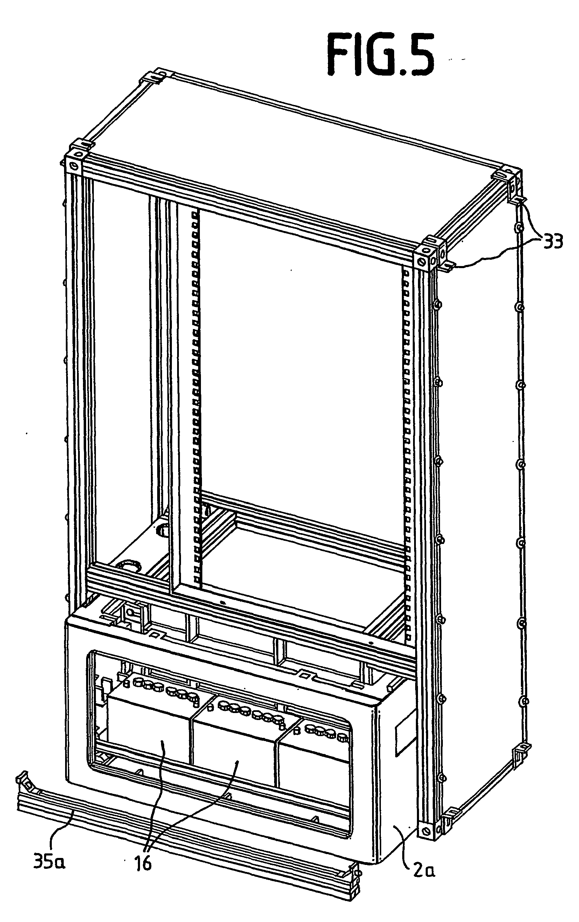

Um diese Positionierung zu erreichen, wird gemäß Fig. 3 und auch der analogen, dreidimensionalen Darstellung der Fig. 5 eine der unteren Querstreben, beispielsweise die vordere untere Querstrebe 35a, aus dem Montagerahmen 6 entfernt und der Montagerahmen 6 dann entlang des Bodens oder nur mit geringem Anheben horizontal so über den oberen Teil 2a' des Sockelkastens 2a geschoben, dass wie beschrieben die Auflageplatten 45 auf der Oberseite des Sockelkastens 2a aufliegen.

Während dieses Überschieben in den Figuren 3 und 5 erst teilweise geschehen ist, zeigt Fig. 6 einen späteren Montagezustand, in dem das Überschieben beendet und auch die vorher entfernte untere Querstrebe 35a wieder am Montagerahmen 6 befestigt ist, und auf der Außenseite des Montagerahmens 6 mit Abstand bereits Seitenwände und Rückwand des Korpus 3 sowie der Deckel 5 aufgesetzt sind, unter Anordnen eines oberen Zwischenteiles 7 zwischen Deckel 5 und dem restlichen Korpus 3, welches Luftaustrittsöffnungen 13 zum Austreten der Luft aus dem Zwischenraum 19 zwischen äußerem Korpus 3 und innerem Montagerahmen 6 ermöglicht.

Die Darstellungen der Fig. 4, deren einzelne Ansichten hinsichtlich der Blickrichtung denen der Figuren 3 entsprechen, zeigen einen demgegenüber nochmals weiteren Montagezustand, in dem der äußere Korpus 3 auch bereits um eine Tür 4 sowie eine Frontblende 14 komplettiert ist.

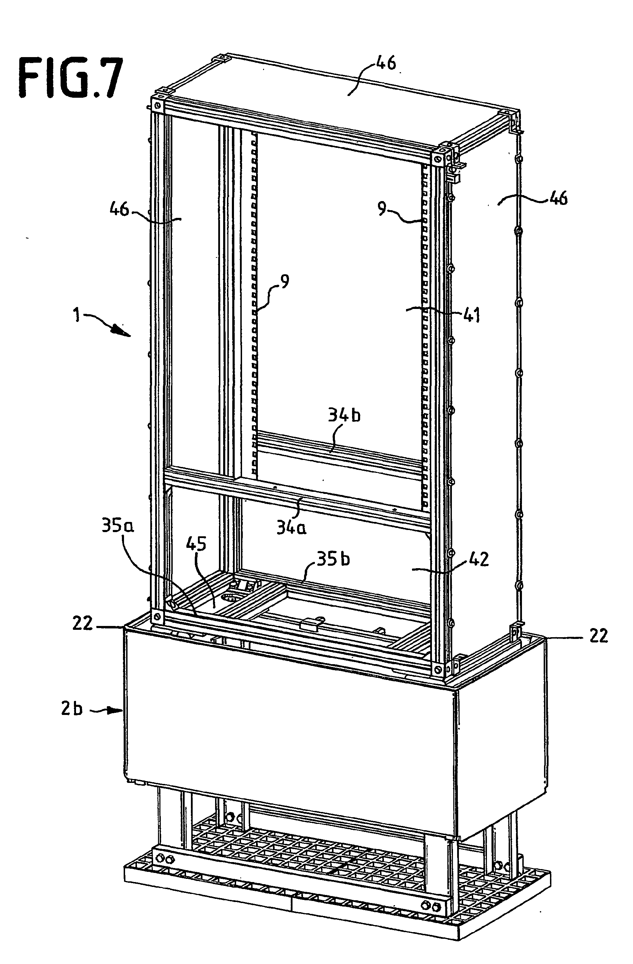

Fig. 7 zeigt den auf einem Sockelkasten 2b aufgesetzten, teilweise fertiggestellten Elektroschrank 1. Der wesentliche Unterschied gegenüber den Darstellungen der Figuren 5 und 6 liegt darin, dass im Fall der Fig. 7 der Elektroschrank 1 mit seiner Unterkante auf der Oberseite eines Sockelkastens 2b und damit insgesamt gemäß der Prinzipdarstellung der Fig. 1 b aufgesetzt ist, denn dieser Sockelkasten 2b wird im wesentlichen vollständig im Erdboden eingesetzt, so dass die Oberkante des Sockelkastens 2b gleichzeitig die Erdoberfläche 22 ist. Wie ersichtlich besteht der Sockelkasten 2b aus einem Gitter als Basis, auf dem die Sockelkonstruktion aufragt, und der im oberen Bereich nahe der Erdoberfläche 22 eine eigene Außenverkleidung besitzt.

Auf der - offenen - Oberseite dieses Sockelkastens 2b ist gemäß Fig. 7 der Montagerahmen 6 des Elektroschrankes 1 befestigt, in dem - als Unterschied zu Fig. 5 und 6 - die Auflageplatten 45, die in den Seitenbereichen von der vorderen zur hinteren Querstrebe durchgehen, nicht an den im mittleren Bereich des Montagerahmens 6 befestigten Querstreben 34a, b sondern an den unteren Querstreben 35a, b befestigt sind.

Damit ergibt sich eine Höhe des Montagerahmens 6 und damit auch des späteren Elektroschrankes 1 oberhalb der Erdoberfläche 22, die der anderen Lösung gemäß den Fig. 5 und 6 entspricht, jedoch steht gemäß Fig. 7 auch der untere Aufnahmeraum 42 zur Aufnahme elektrischer Komponenten zur Verfügung.

Dennoch erstrecken sich die Baugruppenträger 9 auch bei der Lösung gemäß Fig. 7 nur von den mittleren Querstreben 34 zu den oberen Querstreben.

In Fig. 7 sind die Oberseiten sowie die Seitenflächen und auch die Rückseite mit einer Beplankung 46 aus durchgehenden Platten, vorzugsweise aus einem EMV-abschirmenden Material wie etwa Aluminium, beplankt, welche zwischen den Streben des Montagerahmens 6 befestigt sind.

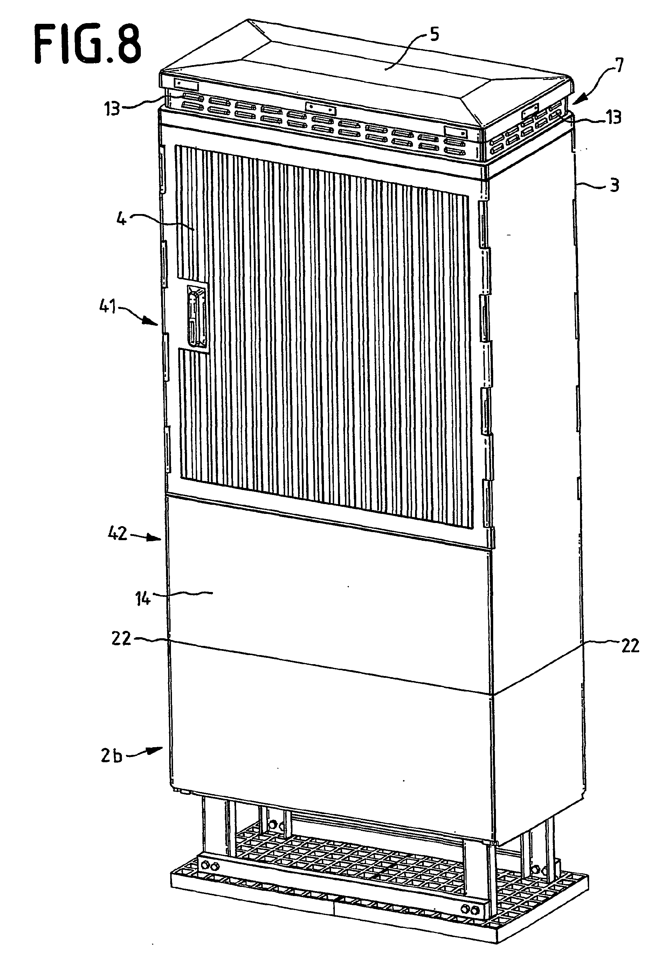

Fig. 8 zeigt den gegenüber Fig. 7 vervollständigten Aufbau des Elektroschrankes, also mit vollständigem, den Montagerahmen 6 umgebenden, Korpus 3, einschließlich eines darauf aufgesetzten oberen Zwischenteiles 7 mit bereits beschriebenen Luftaustrittsöffnungen 13 am Umfang und einem das oberen Zwischenteil 13 nach oben abschließenden Deckel 5.

Die Frontseite des Elektroschrankes ist dabei über die Höhe des oberen Aufnahmeraumes 41, also von der vorderen mittleren Querstrebe 34a bis zur vorderen oberen Querstrebe, mit einer rechts angeschlagenen Tür 4 verschlossen, während der untere Frontbereich, also die Höhe des unteren Aufnahmeraumes 42, mittels einer Frontblende 14 verschlossen ist, die vorzugsweise über Scharniere im unteren Bereich entlang der Unterkante nach vorne aufgeklappt werden kann.

Wenn eine EMV-Abschirmung des Elektroschrankes 1 gewünscht ist, müssen Frontblende 14 und Tür 4 ebenfalls EMV-abschirmend sein und bei Herstellung aus Kunststoff vorzugsweise eine Innenbeschichtung aus EMV-abschirmenden Material wie etwa Aluminium aufweisen.

### BEZUGSZEICHENLISTE

- 1: Elektroschrank
- 2: Sockelkasten
- 3: Korpus
- 4: Tür
- 5: Deckel
- 6: Montagerahmen
- 7: oberes Zwischenteil
- 8: Erdkabel
- 9: Baugruppenträger
- 10: vertikale Längsrichtung
- 11: Trägerplatte
- 12: elektrische Baugruppe
- 13: Luftaustrittsöffnung
- 14: Frontblende
- 16: Batterien
- 18: Bodenblech
- 19: Zwischenraum
- 20: Querrichtung
- 21: Sollbruchelemente
- 22: Erdoberfläche
- 23: Batterie
- 24: Kabeldurchgangsöffnung
- 25: Durchführungsplatte
- 26: Rahmendeckel
- 27: Lufteintrittsöffnung
- 28: Kabelbefestigungsschiene
- 29: Lochreihe
- 30: Rippe
- 31: Zwischenboden
- 32: Rand
- 33: Verbindungselement
- 34a, 34b: Querstreben
- 35a, 35b: Querstreben
- 36: Kühlrippen
- 37: Antrieb
- 38: Löffelrad
- 39: Schaufel
- 40: Tiefe
- 41: oberer Aufnahmeraum
- 42: unterer Aufnahmeraum
- 44: Befestigungsposition
- 45: Auflageplatte
- 46: Beplankung

## Patentansprüche

1. Bausatz zum Erstellen eines Elektroschrankes, welcher der Aufnahme von Schwachstrom-Verteilanlagen dient und insbesondere im Freien aufgestellt werden soll, mit
- einem äußeren Korpus (3),
- einem inneren Montagerahmen (6),
- einer Beplankung (46) für den inneren Montagerahmen (6),
**gekennzeichnet durch**
- mehrere unterschiedlich hinsichtlich Grundfläche und Überstand über dem Erdboden dimensionierte Sockelkästen (2a,b),
- Auflageplatten (45) zum Verbinden des Montagerahmens (6) mit einem Sockelkasten (2a,b) und
- mehrere Befestigungspositionen für die Auflageplatten (45) am Montagerahmen (6).

2. Bausatz nach Anspruch 1,
**dadurch gekennzeichnet, dass**
die Sockelkästen (2a,b) wenigstens einen über die Erdoberfläche vorstehenden Sockelkasten (2a) und einen ebenerdig endenden Sockelkasten (2b) umfassen.

3. Bausatz nach einem der vorhergehenden Ansprüche,
**dadurch gekennzeichnet, dass**
der Montagerahmen 6 zwischen seinem oberen und unteren Ende wenigstens zwei auf gleicher Höhe in Querrichtung (20), der größeren horizontalen Dimension des Elektroschrankes (1), verlaufende Querstreben (34) aufweist, und insbesondere im Verlauf dieser Querstreben (34) die Befestigungspositionen (44) zum Befestigen der Auflageplatten (45) angeordnet sind.

4. Bausatz nach einem der vorhergehenden Ansprüche,
**dadurch gekennzeichnet, dass**
die Auflageplatten (45) in Richtung der Tiefe (40) des Elektroschrankes (1) verlaufen und die beiden parallel horizontal nebeneinanderliegenden Querstreben (34a,b) miteinander verbinden und insbesondere entlang der Querstreben (34a,b) verschiebbar sind.

5. Bausatz nach einem der vorhergehenden Ansprüche,
**dadurch gekennzeichnet, dass**
die Höhenlage der Querstreben (34a,b) am Montagerahmen (6) veränderbar ist.

6. Bausatz nach einem der vorhergehenden Ansprüche,
**dadurch gekennzeichnet, dass**
der Montagerahmen (6) untere und obere Querstreben (35a,b..) am oberen und unteren Ende aufweist und wenigstens eine der unteren Querstreben (35a) vom Montagerahmen (6) demontierbar ist.

7. Bausatz nach einem der vorhergehenden Ansprüche,
**dadurch gekennzeichnet, dass**
der Bausatz Sollbruchelemente (21) umfasst.

8. Bausatz nach einem der vorhergehenden Ansprüche,
**dadurch gekennzeichnet, dass**
die Sollbruchelemente (21) an den Auflageplatten (45) befestigt, insbesondere einstückig zusammen mit diesen ausgebildet sind.

9. Bausatz nach einem der vorhergehenden Ansprüche,
**dadurch gekennzeichnet, dass**
die Sollbruchelemente im Sockelkasten (2a,b..), insbesondere in dem über die Erdoberfläche (22) aufragenden Sockelkasten (2a) zwischen einem oberen Teil (2a') und einem unterhalb der Erdoberfläche liegenden Teil (2a") angeordnet sind.

10. Bausatz nach einem der vorhergehenden Ansprüche,
**dadurch gekennzeichnet, dass**
der Elektroschrank (1) Baugruppenträger (9) zur Befestigung am Montagerahmen (6), insbesondere an dessen Innenflächen, umfasst, und die Baugruppenträger (9) insbesondere aus vertikal verlaufenden Profilstreben bestehen.

11. Bausatz nach einem der vorhergehenden Ansprüche,
**dadurch gekennzeichnet, dass**
die Baugruppenträger (9) sich in vertikaler Richtung entlang des oberen Aufnahmeraumes (41), nämlich von den Querstreben (34a,b) zu den oberen Querstreben (35c,d), erstrecken.

12. Bausatz nach einem der vorhergehenden Ansprüche,
**dadurch gekennzeichnet, dass**
der Montagerahmen (6) eine lichte Weite in Querrichtung (20) aufweist, die größer ist als die Breite des größten Sockelkastens (2a,b) in dieser Richtung.

13. Bausatz nach einem der vorhergehenden Ansprüche,
**dadurch gekennzeichnet, dass**
der Montagerahmen (6) eine Tiefe gemessen von der Innenkante der einen unteren Querstreben (35a,b) bis zur gegenüberliegenden Außenkante in Richtung der Tiefe (40) aufweist, die größer ist als die Tiefe des tiefsten Sockelkastens (2a,b) in Tiefenrichtung (40).

14. Bausatz nach einem der vorhergehenden Ansprüche,
**dadurch gekennzeichnet, dass**
der Bausatz ein Bodenblech (18) mit Kabeldurchgangsöffnungen (24) insbesondere zum Befestigen an den Querstreben (34, 35), insbesondere den unteren Querstreben (35a,b), quer verlaufend in Richtung der Tiefe (40), umfasst.

15. Bausatz nach einem der vorhergehenden Ansprüche,
**dadurch gekennzeichnet, dass**
die Beplankung (46) für den Montagerahmen (6) auf den Außenflächen und/oder Innenflächen des Montagerahmens (6) befestigbar ist und wenigstens die Umfangsflächen des Montagerahmens (6) dicht verschließt.

16. Bausatz nach einem der vorhergehenden Ansprüche,
**dadurch gekennzeichnet, dass**
die Beplankung (46) einen Rahmendeckel (26) umfasst, der den oberen Aufnahmeraum (41) innerhalb des Montagerahmens (6) gegenüber dem darüber liegenden Innenraum des äußeren Korpus (3) abschottet.

17. Bausatz nach einem der vorhergehenden Ansprüche,
**dadurch gekennzeichnet, dass**
der äußere Korpus (3) den inneren Montagerahmen (6) mit Abstand außen umgibt und im unteren Bereich Lufteintrittsöffnungen (27) umfasst.

18. Bausatz nach einem der vorhergehenden Ansprüche,
**dadurch gekennzeichnet, dass**
die äußere Beplankung (46) aus einzelnen Platten für die Seitenwände und Rückwand sowie einer Vorderwand mit wenigstens einer Tür (4) und einem Deckel (5) umfasst.

19. Bausatz nach einem der vorhergehenden Ansprüche,
**dadurch gekennzeichnet, dass**
zwischen dem Deckel (5) und dem unteren Teil des Korpus (3) ein oberes Zwischenteil (7), insbesondere mit Luftaustrittsöffnungen (13) nach außen, vorgesehen ist.

20. Bausatz nach einem der vorhergehenden Ansprüche,
**dadurch gekennzeichnet, dass**
der untere Teil des Korpus (3), also der unterhalb des Zwischenteiles (7) bzw. dem Deckel (5) liegende Teil des Korpus (3) bei geschlossener Tür (4) ein geschlossenes Gehäuse bildet.

21. Bausatz nach einem der vorhergehenden Ansprüche,
**dadurch gekennzeichnet, dass**
der Bausatz Verbindungselemente (33) zum Verbinden des äußeren Korpus (3) mit dem inneren Montagerahmen (6) umfasst.

22. Bausatz nach einem der vorhergehenden Ansprüche,
**dadurch gekennzeichnet, dass**
die Teile des äußeren Korpus (3) aus Kunststoff, insbesondere aus plattenförmigen Kunststoffelementen, insbesondere geschäumtem Kunststoff, insbesondere geschäumten Polykarbonat bestehen.

23. Bausatz nach einem der vorhergehenden Ansprüche,
**dadurch gekennzeichnet, dass**
der innere Montagerahmen (6) aus Profilstäben, insbesondere aus Metall, besteht; die insbesondere miteinander verschraubt sind.

24. Verfahren zum Erstellen eines Elektroschrankes, welcher der Aufnahme von Schwachstrom-Verteilanlagen dient und insbesondere im Freien aufgestellt werden soll, mit folgenden Schritten:
- Befestigen der Querstreben (34a,b) am übrigen Montagerahmen (6) in einer definierten Höhe,
- Anordnen der Auflageplatten (45a,b) an den Befestigungspositionen (44a,b) entweder an den Querstreben (34a,b) oder den unteren Querstreben (35a,b)
- Positionieren des so ausgestatteten Montagerahmens (6) gegenüber dem verbauten Sockelkasten (2a,b)
- Befestigen der Auflageplatten (45) an der Oberseite des Sockelkastens (2a,b).

25. Verfahren nach einem Verfahrensanspruch 24,
**dadurch gekennzeichnet, dass**
vor dem Anordnen der Auflageplatten (45) die Sollbruchelemente (21) an den Auflageplatten (45) befestigt werden.

26. Verfahren nach einem der vorhergehenden Verfahrensansprüche,
**dadurch gekennzeichnet, dass**
vor dem Positionieren des Montagerahmens (6) gegenüber dem Sockelkasten (2a,b) die Baugruppenträger (9) zwischen den oberen Querstreben (35c,d) und den Querstreben (34a,b) bzw. den unteren Querstreben (35a,b) befestigt, insbesondere verschraubt, werden.

27. Verfahren nach einem der vorhergehenden Verfahrensansprüche,
**dadurch gekennzeichnet, dass**
der Montagerahmen (6) gegenüber dem Sockelkasten (2a) positioniert wird durch Überschieben in vertikaler Richtung von oben.

28. Verfahren nach einem der vorhergehenden Verfahrensansprüche,
**dadurch gekennzeichnet, dass**
der Montagerahmen gegenüber dem Sockelkasten (2a) positioniert wird, indem vom Montagerahmen (6) die vordere, untere Querstrebe (35a) entfernt ist und der Montagerahmen (6) in horizontaler Richtung in Richtung der Tiefe (40) über den Sockelkasten (2a) bzw. dessen über die Erdoberfläche vorstehenden oberen Teils (2a') geschoben wird.

29. Verfahren nach einem der vorhergehenden Verfahrensansprüche,
**dadurch gekennzeichnet, dass**
die Beplankung (46) und/oder der äußere Korpus (3) am Montagerahmen (6) befestigt wird nach Ausstattung des Montagerahmens (6) mit den darin aufgenommenen elektrischen, elektronischen und mechanischen Baugruppen im Inneren des Montagerahmens (6).

## Claims

1. A kit for producing an electrical cabinet which is used for receiving low current distribution devices and which shall be set up in particular outdoors, comprising:
- a outer body (3),
- an inner assembly frame (6),
- a covering (46) for the inner assembly frame (6),
**characterized by**
- plural pedestal cases (2a, b) that are sized differently with respect to base surface and an extension above ground,
- mounting plates (45) for connecting the assembly frame (6) with a pedestal case (2a, b) and
- plural attachment positions for the mounting plates (45) at the assembly frame (6).

2. The kit according to claim 1, **characterized in that** the pedestal cases (2a, b) include at least one pedestal case (2a) extending above ground level and one pedestal case (2b) terminating at ground level.

3. The kit according to one of the preceding claims, **characterized in that** the assembly frame includes at least two transversal beams (34) arranged between its upper end and its lower end and extending at a constant elevation in transversal direction (20) which is the greater horizontal dimension of the electrical cabinet (1), and **in that** in particular attachment positions (44) for attaching the mounting plates (45) are arranged along the transversal beams (34).

4. The kit according to one of the preceding claims, **characterized in that** the mounting plates (45) extend in a direction of a depth (40) of the electrical cabinet (1) and connect two transversal beams (34a, b) with one another that are arranged parallel and horizontally adjacent to one another and **in that** the mounting plates are in particular moveable along the transversal beams (34a, b).

5. The kit according to one of the preceding claims, **characterized in that** the elevation position of the transversal beams (34a, b) at the assembly frame (6) is variable.

6. The kit according to one of the preceding claims, **characterized in that** the assembly frame (6) includes lower and upper transversal beams (35a, b...) at the upper and lower end and at least one of the lower transversal beams (35a) is detachable for the assembly frame (6).

7. The kit according to one of the preceding claims, **characterized in that** the kit includes rated break elements (21).

8. The kit according to one of the preceding claims, **characterized in that** the rated break elements (21) are attached at the mounting plates (45), in particular integrally configured therewith.

9. The kit according to one of the preceding claims, **characterized in that** the rated break elements are arranged in the pedestal case (2a, b...), in particular in the pedestal case (2a) extending above ground level (22) between an upper portion (2a') and a portion (2a") arranged below ground level.

10. The kit according to one of the preceding claims, **characterized in that** the electrical cabinet (1) includes sub assembly carriers (9) for attachment at the assembly frame (6) in particular at its inner surfaces and the sub assembly carriers (9) include in particular vertically extending profile struts.

11. The kit according to one of the preceding claims, **characterized in that** the sub assembly carriers (9) extend in vertical direction along the upper receiver cavity (41), namely from the transversal struts (34a, b) to the upper transversal struts (35c, d).

12. The kit according to one of the preceding claims, **characterized in that** the assembly frame (6) has an inner width in transversal direction (20) which is greater than the width of the largest pedestal case (2a, b) in this direction.

13. The kit according to one of the preceding claims, **characterized in that** the assembly frame (6) has a depth measured from an inner edge of a lower transversal strut (35a, b) to an opposite outer edge in a direction of the depth of (40) which is greater than the depth of the deepest pedestal case (2a, b) in the depth direction (40).

14. The kit according to one of the preceding claims, **characterized in that** the kit includes a base plate (18) with cable pass through openings (24), in particular for attaching at the transversal struts (34, 35), in particular at the lower transversal struts (35a, b) and extending transversally in the direction of the depth (40).

15. The kit according to one of the preceding claims, **characterized in that** the covering (46) for the assembly frame (6) is attachable at outer surfaces and/or inner surfaces of the assembly frame (6) and closes at least circumferential surfaces of the assembly frame (6) tightly.

16. The kit according to one of the preceding claims, **characterized in that** the covering (46) includes a frame cover (26) which seals the upper receiving cavity (41) within the assembly frame (6) relative to the inner cavity of the outer body (3) arranged there above.

17. The kit according to one of the preceding claims **characterized in that** the outer body (3) envelopes the inner assembly frame (6) with a distance on an outside and includes air entry openings (27) in its lower portion.

18. The kit according to one of the preceding claims, **characterized in that** the outer covering (46) includes individual plates for lateral walls and a rear wall and a front wall with at least one door (4) and a cover (5).

19. The kit according to one of the preceding claims, **characterized in that** an upper intermediary element (7), in particular with air outlet openings (13) towards an outside is provided between the cover (5) and the lower portion of the body (3).

20. The kit according to one of the preceding claims, **characterized in that** the lower portion of the body (3), thus the portion of the body (3) that is arranged below the intermediary element (7) or the cover (5) forms a closed housing when the door (4) is closed.

21. The kit according to one of the preceding claims, **characterized in that** the kit includes connection elements (33) for connecting the outer body (3) with the inner assembly frame (6).

22. The kit according to one of the preceding claims, **characterized in that** the elements of the outer body (3) are made from plastic material, in particular from plate shaped plastic elements, in particular from foamed plastic material, in particular foamed poly carbonate.

23. The kit according to one of the preceding claims, **characterized in that** the inner assembly frame (6) is made from profile rods, in particular made from metal which are in particular bolted together.

24. A method for producing an electrical cabinet which is used for receiving low current distribution devices and which is configured to be set up in particular outdoors, comprising the following steps:
- attaching the transversal struts (34a, b) at a remaining assembly frame at a defined elevation,
- arranging the mounting plates (45a, b) at attachment positions (44a, b) either at the transversal beams (34a, b) or at the lower transversal beams (35a, b),
- positioning the assembly frame (6) thus configured relative to the installed pedestal case (2a, b),
- attaching the mounting plates (45) at a top side of the pedestal case (2a, b).

25. The method according to the method claim (24) **characterized in that** rated break elements (21) are attached at the mounting plates (45) before the mounting plates (45) are arranged.

26. The method according to one of the preceding method claims, **characterized in that** the subassembly carriers (9) are attached between the upper transversal struts (35c, d) and the transversal struts (34a, b) or the lower transversal struts (35a, b), in particular bolted down, before positioning the assembly frame (6) relative to the pedestal case (2a, b).

27. The method according to one of the preceding method claims, **characterized in that** the assembly frame (6) is positioned relative to the pedestal case (2a) by sliding over in vertical direction from above.

28. The method according to one of the preceding method claims, **characterized in that** the assembly frame (6) is positioned relative to the pedestal case (2a) **in that** the frontal lower transversal strut (35a) is removed from the assembly frame (6) and the assembly frame (6) is slid in horizontal direction in a direction of the depth (40) over the pedestal case (2a) or its upper portion (2a')
extending above ground.

29. The method according to one of the preceding method claims, **characterized in that** the covering (46) and/or the outer body (3) is attached at the assembly frame (6) after configuring the assembly frame (6) with the electrical, electronic and mechanical assemblies received therein in the interior of the assembly frame (6).

## Revendications

1. Kit pour la réalisation d'une armoire électrique servant au logement d'installations de distribution et étant destiné en particulier à une installation à l'extérieur, comprenant
- un corps externe (3),
- un cadre de montage interne (6),
- un habillage (46) pour le cadre interne de montage (6),
**caractérisé par**
- plusieurs caissons-socles (2a, b) dimensionnés de manière différente en termes de surface de base et de débord au-dessus du sol,
- des plaques d'application (45) pour la liaison du cadre de montage (6) à un caisson-socle (2a, b) et
- plusieurs positions de fixation pour les plaques d'application (45) sur le cadre de montage (6).

2. Kit selon la revendication 1,
**caractérisé en ce que** les caissons-socles (2a, b) comprennent au moins un caisson-socle (2a) faisant saille au-dessus de la surface de la terre et un caisson-socle (2b) se terminant au niveau de la terre.

3. Kit selon l'une des revendications précédentes,
**caractérisé en ce que** le cadre de montage (6) présente entre son extrémité supérieure et son extrémité inférieure au moins deux entretoises transversales (34) s'étendant à la même hauteur dans la direction transversale (20) de la dimension horizontale la plus grande de l'armoire électrique (1) et **en ce qu'**en particulier les positions de fixation (44) pour la fixation des plaques d'application (45) sont disposées dans l'alignement de ces entretoises transversales (34).

4. Kit selon l'une des revendications précédentes,
**caractérisé en ce que** les plaques d'application (45) s'étendent en direction de la profondeur (40) de l'armoire électrique (1) et les deux entretoises transversales (34a, b) juxtaposées parallèles et horizontales sont reliées entre elles et sont coulissantes en particulier le long des entretoises transversales (34a, b).

5. Kit selon l'une des revendications précédentes,
**caractérisé en ce que** la position en hauteur des entretoises transversales (34a, b) est modifiable sur le cadre de montage (6).

6. Kit selon l'une des revendications précédentes,
**caractérisé en ce que** le cadre de montage (6) présente des entretoises transversales inférieures et supérieures (35a, b..) sur l'extrémité supérieure et inférieure et au moins l'une des entretoises transversales inférieures (35a) est démontable du cadre de montage (6).

7. Kit selon l'une des revendications précédentes,
**caractérisé en ce que** le kit comprend des éléments de rupture de consigne (21).

8. Kit selon l'une des revendications précédentes,
**caractérisé en ce que** les éléments de rupture de consigne (21) sont fixés sur les plaques d'application (45), en particulier elles sont formées d'une seule pièce avec ces dernières.

9. Kit selon l'une des revendications précédentes,
**caractérisé en ce que** les éléments de rupture de consigne sont disposés dans le caisson-socle (2a, b..) en particulier dans le caisson-socle (2a) faisant saillie au-dessus de la surface de la terre (22), entre une partie supérieure (2a') et une partie (2a") se trouvant en dessous de la surface de la terre.

10. Kit selon l'une des revendications précédentes,
**caractérisé en ce que** l'armoire électrique (1) comprend des supports de groupe de construction (9) pour la fixation sur le cadre de montage (6), en particulier sur leurs surfaces internes et les supports de groupe de construction (9) se composent en particulier d'entretoises profilées verticales.

11. Kit selon l'une des revendications précédentes,
**caractérisé en ce que** les supports de groupe de construction (9) s'étendent dans la direction verticale le long de l'espace de logement supérieur (41), notamment depuis les entretoises transversales (34a, b) aux entretoises transversales supérieures (35c, d).

12. Kit selon l'une des revendications précédentes,
**caractérisé en ce que** le cadre de montage (6) présente une largeur intérieure dans la direction transversale (20) qui est supérieure à la largeur du plus grand caisson-socle (2a, b..) dans cette direction.

13. Kit selon l'une des revendications précédentes,
**caractérisé en ce que** le cadre de montage (6) présente une profondeur mesurée depuis le bord interne de l'entretoise transversale inférieure (35a, b) jusqu'au bord externe opposé en direction de la profondeur (40) qui est supérieure à la profondeur du caisson-socle (2a, b) dans la direction de profondeur (40).

14. Kit selon l'une des revendications précédentes,
**caractérisé en ce que** le kit comprend une tôle de fond (18) avec des ouvertures de passage de câbles (24) en particulier pour la fixation sur les entretoises transversales (34, 35), en particulier sur les entretoises transversales inférieures (35a, b), s'étendant transversalement dans la direction de la profondeur (40).

15. Kit selon l'une des revendications précédentes,
**caractérisé en ce que** l'habillage (46) peut être fixé pour le cadre de montage (6) sur les surfaces externes et/ou les surfaces internes du cadre de montage (6) et ferme hermétiquement au moins les surfaces périphériques du cadre de montage (6).

16. Kit selon l'une des revendications précédentes,
**caractérisé en ce que** l'habillage (46) comprend un couvercle de cadre (26) qui isole l'espace supérieur de logement (41) à l'intérieur du cadre de montage (6) par rapport à l'espace intérieur du corps externe (3), se trouvant au-dessus.

17. Kit selon l'une des revendications précédentes,
**caractérisé en ce que** le corps externe (3) entoure le cadre de montage (6) interne à distance à l'extérieur et comprend dans la zone inférieure des orifices d'entrée d'air (27).

18. Kit selon l'une des revendications précédentes,
**caractérisé en ce que** l'habillage externe (46) se compose de plaques séparées pour les parois latérales et d'une paroi arrière ainsi que d'une paroi avant avec au moins une porte (4) et un couvercle (5).

19. Kit selon l'une des revendications précédentes,
**caractérisé en ce qu'**entre le couvercle (5) et la partie inférieure du corps (3), il est prévu une partie intermédiaire supérieure (7), en particulier avec des orifices de sortie d'air (13) vers l'extérieur.

20. Kit selon l'une des revendications précédentes,
**caractérisé en ce que** la partie inférieure du corps (3), donc la partie du corps (3), qui se trouve en dessous de la partie intermédiaire (7) respectivement du couvercle (5) forme un carter fermé quand la porte (4) est fermée.

21. Kit selon l'une des revendications précédentes,
**caractérisé en ce que** le kit comprend des éléments de connexion (33) pour connecter le corps externe (3) au cadre interne de montage (6).

22. Kit selon l'une des revendications précédentes,
**caractérisé en ce que** les parties du corps externe (3) se composent de matière synthétique, en particulier d'éléments en matière synthétique en forme de plaques, en particulier en mousse synthétique, en particulier en mousse de polycarbonate.

23. Kit selon l'une des revendications précédentes,
**caractérisé en ce que** le cadre de montage interne (6) se compose de barres profilées, en particulier en métal, qui sont vissées en particulier entre elles.

24. Procédé pour la réalisation d'une armoire électrique servant au logement d'installations de distribution et étant destinée en particulier à une installation à l'extérieur, comprenant les étapes suivantes :
- la fixation des entretoises transversales (34a, b) sur le reste du cadre de montage (6) à une hauteur définie,
- la disposition des plaques d'application (45a, b) sur les positions de fixation (44a, b) soit sur les entretoises transversales (34a, b) soit sur les entretoises transversales inférieures (35a, b),
- le positionnement du cadre de montage (6) ainsi équipé par rapport au caisson-socle (2a, b) monté,
- la fixation des plaques d'application (45) sur la face supérieure du caisson-socle (2a, b).

25. Procédé selon une revendication de procédé 24,
**caractérisé en ce qu'**avant la disposition des plaques d'application (45), les éléments de rupture de consigne (21) sont fixés sur les plaques d'application (45).

26. Procédé selon l'une des revendications précédentes,
**caractérisé en ce qu'**avant le positionnement du cadre de montage (6) par rapport au caisson-socle (2a, b), les supports de groupe de construction (9) sont fixés en particulier vissés enter les entretoises transversales supérieures (35c, d) et les entretoises transversales (34a, b) respectivement les entretoises transversales inférieures (35a, b).

27. Procédé selon l'une des revendications précédentes,
**caractérisé en ce que** le cadre de montage (6) est positionné par rapport au caisson-socle (2a) par coulissement vertical par le haut.

28. Procédé selon l'une des revendications précédentes,
**caractérisé en ce que** le cadre de montage est positionné par rapport au caisson-socle (2a), dans le fait que l'entretoise transversale avant inférieure (35a) est retirée du cadre de montage (6) et le cadre de montage (6) est poussé dans le sens horizontal en direction de la profondeur (40) au-dessus du caisson-socle (2a) respectivement au-dessus de la partie supérieure (2a') faisant saillie au-dessus de la surface de la terre.

29. Procédé selon l'une des revendications précédentes,
**caractérisé en ce que** l'habillage (46) et/ou le corps externe (3) est fixé sur le cadre de montage (6) après l'équipement du cadre de montage (6) avec les groupes de composants mécaniques, électroniques, électriques logés à l'intérieur du cadre de montage (6).
